(19)

Europäisches
Patentamt
European
Patent Office
Office européen
des brevets

(11) **EP 1 696 243 B1**

(12) **EUROPÄISCHE PATENTSCHRIFT**

(45) Veröffentlichungstag und Bekanntmachung des Hinweises auf die Patenterteilung:
**23.04.2008  Patentblatt 2008/17**

(51) Int Cl.:
***G01R 33/34*** *(2006.01)*

(21) Anmeldenummer: **06002275.3**

(22) Anmeldetag: **03.02.2006**

(54) **Verwendung eines miniaturisierten Detektionsspulenkörpers zur NMR-Spektroskopie**

Use of a miniaturized receiver coil body for NMR spectroscopy

Utilisation d'un corps de bobine de détection miniaturisé pour la spectroscopie RMN

(84) Benannte Vertragsstaaten:
**DE FR GB**

(30) Priorität: **25.02.2005  DE 102005008798**

(43) Veröffentlichungstag der Anmeldung:
**30.08.2006  Patentblatt 2006/35**

(73) Patentinhaber: **Qimonda AG**
**81739 München (DE)**

(72) Erfinder: **Martin, Alfred**
**81825 München (DE)**

(74) Vertreter: **Müller-Boré & Partner**
**Patentanwälte**
**Grafinger Strasse 2**
**81671 München (DE)**

(56) Entgegenhaltungen:
**US-A1- 2002 068 369**

• **LINDEBERG M ET AL: "Interconnected nanowire clusters in polyimide for flexible circuits and magnetic sensing applications" SENSORS AND ACTUATORS A, ELSEVIER SEQUOIA S.A., LAUSANNE, CH, Bd. 105, Nr. 2, 15. Juli 2003 (2003-07-15), Seiten 150-161, XP004428584 ISSN: 0924-4247**
• **JUN-BO YOON ET AL: "High-performance electroplated solenoid-type integrated inductor (SI<2>) for RF applications using simple 3D surface micromachining technology" ELECTRON DEVICES MEETING, 1998. IEDM '98 TECHNICAL DIGEST., INTERNATIONAL SAN FRANCISCO, CA, USA 6-9 DEC. 1998, PISCATAWAY, NJ, USA,IEEE, US, 6. Dezember 1998 (1998-12-06), Seiten 544-547, XP010321526 ISBN: 0-7803-4774-9**
• **MAGIN R L ET AL: "MINIATURE MAGNETIC RESONANCE MACHINES" IEEE SPECTRUM, IEEE INC. NEW YORK, US, Bd. 34, Nr. 10, Oktober 1997 (1997-10), Seiten 51-61, XP000738785 ISSN: 0018-9235**
• **H.WENSINK ET AL.: "Measuring reaction kinetics in a lab-on-a-chip by microcoil NMR" LAB CHIP, Bd. 5, 28. Januar 2005 (2005-01-28), Seiten 280-284, XP002372082**
• **FOLL H ET AL: "Formation and application of porous silicon" MATERIALS SCIENCE AND ENGINEERING R: REPORTS, ELSEVIER SEQUOIA S.A., LAUSANNE, CH, Bd. 39, Nr. 4, 1. November 2002 (2002-11-01), Seiten 93-141, XP004386810 ISSN: 0927-796X**

**Beschreibung**

Die vorliegende Erfindung betrifft die Verwendung eines miniaturisierten Detektionsspulenkörpers zur NMR-spektroskopischen Analyse von chemischen Verbindungen in der Flüssigphase.

Die Kernresonanz-Spektroskopie, auch als NMR-Spektroskopie (nuclear magnetic resonance) bezeichnet, ist eines der wichtigsten und aussagekräftigsten Verfahren zur Strukturaufklärung von Molekülen. Die Untersuchungen erfolgen überwiegend in kondensierter Phase, das heißt in Lösung oder im Festkörper. Der Vorteil dieses Verfahrens gegenüber anderen Verfahren liegt darin, daß Aussagen über die Struktur von Molekülen auch in Mehrkomponentensystemen erhalten werden können, ohne daß eine a priori Kenntnis der Bestandteile erforderlich ist. Häufig werden zur Strukturaufklärung chemischer Verbindungen auch kombinierte Verfahren verwendet, das heißt Verfahren, bei denen zunächst eine Auftrennung eines Mehrkomponentensystems in die einzelnen Komponenten erfolgt, bevor die einzelnen Komponenten dann getrennt analysiert werden. Ein Beispiel für ein derartiges integriertes System stellt die Gaschromatographie-Massenspektroskopie (GC-MS) dar, mit der Substanzen noch im Nanogrammbereich detektiert und analysiert werden können. Durch die Massenspektroskopie ist allerdings nur eine beschränkte Information über die Struktur einer chemischen Verbindung zugänglich. Außerdem hat dieses Verfahren den Nachteil, daß die Probe durch die Untersuchung zerstört wird, was gerade bei Proben, die besonders wertvoll oder nur in äußerst geringen Mengen vorhanden sind, problematisch ist. Diesen Nachteil hat die NMR-Spektroskopie dagegen nicht, da bei der NMR-spektroskopischen Untersuchung die Probe nicht zerstört wird. Daher sind Analyseverfahren wünschenswert, bei denen ein Trennungssystem, wie beispielsweise die Kapillarelektrophorese oder die Flüssigchromatographie, mit der NMR-Spektroskopie in einem integrierten System kombiniert wird.

Die inhärente Unempfindlichkeit des NMR-Verfahrens hat jedoch dessen Brauchbarkeit als Erfassungsverfahren für eine Flüssigphasenanalyse von sehr kleinen Proben begrenzt. So können mit handelsüblichen NMR-Spektrometern lediglich Mikrogramm-Mengen einer Substanz routinemäßig untersucht werden, wobei Probenröhrchen mit einem Durchmesser von 5 mm und einem Lösungsvolumen von etwa 500 $\mu$l verwendet werden. Mengen im Mikrogrammbereich können dagegen nur in äußerst langwierigen Messungen und mit verkleinerten Probenröhrchen (1 mm) bzw. Lösungsvolumen (1 $\mu$l) untersucht werden. Noch kleinere Probenvolumen sind jedoch schwer realisierbar, was einer Anwendung in Verbindung mit der Kapillarelektrophorese oder der Flüssigchromatographie im Wege steht. Gerade in Hinblick auf die chemische Synthese und die Biotechnologie, bei welchen eine effiziente Analyse von Proben im Hochdurchsatzbereich benötigt wird, wäre jedoch ein solches Verfahren wünschenswert.

Das Problem der geringen Empfindlichkeit kann allerdings durch die Verwendung miniaturisierter Detektionsspulen in der NMR-Meßvorrichtung gelöst werden. Durch kleinere Spulen kann die Empfindlichkeit gegenüber herkömmlichen Spulen deutlich verbessert werden. Eine maßgebliche Größe bei der Beurteilung der Empfindlichkeit einer Messung ist das Signal/Rausch-Verhältnis (S/N). Dieses ist proportional zum Probenvolumen $V_P$ und zur Stärke des Hochfrequenzfeldes $B_1$. Außerdem ist S/N antiproportional zur Wurzel des Widerstandes der Detektionsspule R. Da R proportional zum Spulenradius $r_s$ ist, gilt:

$$S/N \sim V_P \cdot B_1 / r_s^{1/2}$$

Folglich kann das Signal/Rausch-Verhältnis maximiert werden, indem der Spulendurchmesser verringert wird. Um aber bei einem verringerten Spulenradius ein zufriedenstellendes Signal zu erhalten, müsste der Spuleninnendurchmesser so gut wie möglich an die Probengröße angepasst sein.

In DE 199 27 976 A1 ist für eine Verwendung bei einer Flüssigphasenanalyse ein miniaturisiertes Gesamtanalysesystem mit einem NMR-Erfassungsfach, um das sich eine HF-Mikrospule befindet, beschrieben. Allerdings ist bei Verwendung der in DE 199 27 976 A1 beschriebenen Anordnung die Übereinstimmung der Größe der Probe mit der Größe der NMR-Detektionsspule nicht optimal, wodurch die Empfindlichkeit der NMR-spektroskopischen Messung beschränkt ist.

In US-A-2002/0068369 wird die Einbettung einer Solenoidspule in ein poröses Trägermaterial mit einander gegenüberliegenden Oberflächen beschrieben, wobei die Spulenwindungen durch die Poren des Trägermaterials von der ersten zur zweiten Oberfläche verlaufen und durch Leiterstrukturen auf den beiden Oberflächen miteinander verbunden sind. In Sensors and Actuators A 105 (2003) 150-161 wird die Einbettung von Nanodrähten in Makroporen von Polyimid zur Herstellung flexibler Schaltkreise mit dreidimensionalen elektronischen Mikrokomponenten, wie etwa Induktionsspulen, beschrieben, wobei die Nanodrähte durch lithografisch strukturierte metallische Oberflächenschichten miteinander verbunden sind.

Der vorliegenden Erfindung liegt somit die Aufgabe zugrunde, die Verwendung eines miniaturisierten Detektionsspulenkörpers in einer NMR-Messeinrichtung zu ermöglichen, welche es erlaubt, noch kleinste Probenmengen, insbesondere auch solche von weniger als 1 $\mu$l zu vermessen, wobei aber dennoch eine zufriedenstellende Signalintensität erreicht werden soll.

Diese Aufgabe wird durch die in den Ansprüchen gekennzeichneten Verwendungen gelöst.

Die Empfindlichkeit der NMR-spektroskopischen Messung läßt sich erfindungsgemäß dadurch verbessern, dass eine miniaturisierte NMR-Detektionsspule in ein makroporöses Substrat eingebettet wird, durch das gleichzeitig auch der Analyt geführt wird. Gemäß der vorliegenden Erfindung dient das makroporöse Trägermaterial bzw. Substrat als Matrix für die Spule und gleichzeitig als Träger des Analyten. Dadurch wird eine nahezu optimale Übereinstimmung der Größe der Probe mit der Größe der NMR-Detektionsspule erreicht.

Unter Poren sind im Rahmen der vorliegenden Erfindung Poren zu verstehen, die sich durch das Trägermaterial von der ersten zur zweiten Oberfläche erstrecken, d.h. Durchgangslöcher. Bereichsweise können aber auch Poren, die an einem Ende verschlossen sind, d.h. Sacklöcher, in dem Trägermaterial, insbesondere in den Bereichen, in denen keine Spulenwindung vorliegt, angeordnet sein.

Das makroporöse Trägermaterial der vorliegenden Erfindung unterliegt bezüglich der Materialwahl keiner Beschränkung, solange es Poren mit einem Porendurchmesser von Porendurchmesser von 500 nm bis 100 $\mu$m, vorzugsweise 2 bis 20 $\mu$m aufweist. Hieraus ergeben sich Aspektverhältnisse von Porentiefe zu Porenöffnung von größer 10:1, vorzugsweise von größer 20:1, mehr bevorzugt 40:1. Die Dicke des makroporösen Trägermaterials beträgt 100 bis 5.000 $\mu$m, vorzugsweise 300 bis 600 $\mu$m. Der Abstand von Porenmitte zu Porenmitte (Pitch), d.h. zweier zueinander benachbarter bzw. angrenzender Poren beträgt üblicherweise 1 bis 100 $\mu$m, vorzugsweise 3 bis 50 $\mu$m. Die Porendichte liegt im Bereich von $10^4$ bis $10^8$/cm$^2$.

Insbesondere kann das erfindungsgemäß verwendete makroporöse Trägermaterial auf Basis von Kunststoff, Glas, $Al_2O_3$ oder Silizium sein. Vorzugsweise wird makroporöses Silizium als Trägermaterial im Rahmen der vorliegenden Erfindung eingesetzt.

Das vorzugsweise verwendete makroporöse Silizium kann dabei dotiert, vorzugsweise n-dotiert, oder undotiert sein. Ein solches makroporöses Silizium kann beispielsweise nach dem in EP-A1-0 296 348 beschriebenen Verfahren hergestellt werden. Die Herstellung der Lochöffnungen bzw. Poren erfolgt bevorzugt auf elektrochemischem Wege, wobei eine elektrochemische Ätzung in einem flußsäurehaltigen Elektrolyten unter Anlegen eines konstanten oder sich zeitlich ändernden Potentials durchgeführt wird, wobei die aus Silizium bestehende Schicht oder das Substrat als positiv gepolte Elektrode einer Elektrolysierzelle geschaltet wird. Die Herstellung derartiger Löcher kann bespielsweise erreicht werden, wie in V. Lehmann, J. Electrochem. Soc. 140, 1993, Seiten 2836 ff., beschrieben. Im Rahmen der vorliegenden Erfindung können als makroporöses Substrat beispielsweise aber auch andere Halbleitersubstrate, wie z.B. GaAs-Substrate, oder mit $Si_3N_4$ beschichtete Glassubstrate vorgesehen werden.

Die Makroporen können dabei beispielsweise im wesentlichen rund, ellipsenförmig oder im wesentlichen quadratisch gestaltet sein.

Im Fall von makroporösem Silizium als makroporösen Trägermaterial weist der erfindungsgemäß verwendete miniaturisierte Detektionsspulenkörper eine Isolationsschicht aus $SiO_2$ oder $Si_3N_4$, welche auf die im Wesentlichen vollständige Oberfläche des makroporösen Siliziums aufgebracht ist, auf. Wenn die vorstehend genannte Isolationsschicht des erfindungsgemäßen Substrates aus $SiO_2$ aufgebaut ist, so beträgt deren Dicke üblicherweise 10 bis 100 nm.

Vorzugsweise ist die Porendichte des miniaturisierten Detektionsspulenkörpers im Feldbereich der Spule vergrößert. In diesem Fall kann die Porendichte bis zu $10^{10}$/cm$^2$ betragen.

Durch das Einbetten des Spulenkörpers in das erfindungsgemäß verwendete makroporöse Trägermaterial ergibt sich eine NMR-HF-Spule mit einem Querschnitt von weniger als 500 $\mu$m x 500 $\mu$m. Der minimale Abstand der Spulenwindungen wird durch den Porenabstand bzw. Pitch begrenzt.

Der Ausdruck "Spule" bzw. "Detektionsspulenkörper" wird hier verwendet, um auf einen Hochfrequenzresonator zu verweisen, der ein Magnetfeld ($B_1$) erzeugt, das orthogonal zu dem Hauptmagnetfeld ($B_0$) ist. Üblicherweise ist die Spule als Solenoidspule gestaltet.

Die Spule kann aus einem beliebigen Material aufgebaut sein, das die leitfähigen Eigenschaften der Spule optimiert, wie z.B. Silber, Gold oder Kupfer. In einer bevorzugten Ausführungsform der vorliegenden Erfindung ist das Spulenmaterial der in das makroporöse Trägermaterial eingebetteten Spule auf Basis von Kupfer.

Ein Verfahren zur Herstellung des miniaturisierten Detektionsspulenkörpers umfaßt die Schritte :

(i) Bereitstellen eines wie vorstehend beschriebenen porösen Trägermaterials,
(ii) gegebenenfalls Aufbringen einer Isolationsschicht,
(iii) Abscheiden einer elektrisch leitenden Grundmetallisierungschicht ("seed layer"),
(iv) Strukturieren der elektrisch leitenden Grundmetallisierungschicht ("seed layer") mittels doppelseitiger Lithographie, und
(v) galvanisches Abscheiden eines zur Ausbildung einer NMR-Spule geeigneten leitfähigen Materials, wodurch das galvanisch abgeschiedene leitfähige Material eine in das makroporöse Trägermaterial eingebettete Spule bildet.

Vorzugsweise umfasst das Verfahren die folgenden Schritte:

(i) Bereitstellen eines wie vorstehend beschriebenen porösen Trägermaterials auf Basis von makroporösem Silizium,
(ii) Aufbringen einer Isolationsschicht, ausgewählt aus $SiO_2$ oder $Si_3N_4$,
(iii) Abscheiden einer elektrisch leitenden Grundmetallisierungschicht ("seed layer"),
(iv) Strukturieren der elektrisch leitenden Grundme-

tallisierungsschicht mittels doppelseitiger Lithographie, und

(v) galvanisches Abscheiden von Kupfer, wobei das galvanisch abgeschiedene Kupfer eine in das makroporöse Trägermaterial eingebettete Spule bildet.

Das Aufbringen einer Isolationsschicht in Schritt (ii) erfolgt in der Regel über die Gesamtoberfläche des makroporösen Trägermaterials, d.h. einschließlich der gesamten Porenoberflächen, beispielsweise mittels Sputtertechniken oder CVD-Verfahren. Diese Schicht dient unter anderem dazu, einen Kurzschluss zwischen den Spulenwindungen zu verhindern. Anschließend wird auf dieser Isolationsschicht ganzflächig eine elektrisch leitende Grundmetallisierung ("seed layer") abgeschieden. Diese elektrisch leitende Grundmetallisierungsschicht wird anschließend mittels einer doppelseitigen Lithographie, d.h. auf Vorder- und Rückseite, entsprechend der gewünschten Spulenkonfiguration strukturiert und dient dann als entsprechende Startschicht für das anschließende Galvanisieren in Schritt (v). Derartige Lithographieverfahren zur Strukturierung leitfähiger Schichten sind einem Fachmann wohlbekannt. Anschließend wird durch Kontaktierung des Trägermaterials wie z.B. ein Si-Wafer galvanisch beispielsweise Kupfer abgeschieden. Die Abscheidung erfolgt selektiv nur an den Stellen bzw. Bereichen, an denen eine elektrisch leitende Grundmetallisierung ("seed layer") vorliegt. Die Abscheidung einer solchen elektrisch leitenden Grundmetallisierung ("seed layer") kann mittels physikalischer Aufdampfverfahren oder chemischer Abscheidung (CVD) erfolgen. Das Material der elektrisch leitenden Grundmetallisierung ("seed layer") unterliegt keiner spezifischen Beschränkung. So kann beispielsweise beim ECD (electrical copper deposition) als "seed layer" eine aufgedampfte, beispielsweise 200 nm dicke Kupferschicht verwendet werden.

Alternativ kann das Verfahren die folgenden Schritte umfassen:

(i) Bereitstellen eines wie vorstehend beschriebenen porösen Trägermaterials auf Basis von makroporösem Silizium,
(ii) Aufbringen einer Isolationsschicht, ausgewählt aus $SiO_2$ oder $Si_3N_4$,
(iii) Abscheiden einer Precursor-Schicht,
(iv) Strukturieren der Precursor-Schicht mittels doppelseitiger Lithographie, und
(v) Aufbringen einer zur Ausbildung einer NMR-Spule geeigneten leitfähigen Materials mittels stromlosen Metallisieren bzw. electroless-plating, wobei das aufbrachte leitfähige Material eine Spule bildet.

Im Schritt (v) des Verfahrens erfolgt eine stromlose bzw. chemische Metallisierung ("electroless plating") eines zur Ausbildung einer NMR-Spule geeigneten leitfähigen Materials aus einem wässrigen Elektrolyten auf den Stellen bzw. Bereichen der zuvor strukturierten Precursorschicht. Die in Schritt (v) des Verfahrens einsetzbaren Elektrolytzusammensetzungen sind prinzipiell aus der Technik der Oberflächenbehandlung, der Korrisionsbehandlung oder der Leiterplattenproduktion bekannt. So können im Rahmen des Verfahrens Metalle wie insbesondere Nickel, Kupfer, Platin, Silber und Gold sowie deren Legierungen, vorzugsweise Kupfer, aus wässriger Lösung, d.h. aus deren Metallsalze, stromlos abgeschieden werden. Derartige Elektrolytzusammensetzungen sind im Stand der Technik bekannt und werden beispielsweise zu Korrosionsschutzzwecken bzw. zur Erzeugung von elektrischer Leitfähigkeit auf stark strukturierten, unebenen Oberflächen benutzt, für die eine Metallisierung im Vakuum aus Verfahrens- oder Kostengründen nicht in Frage kommt. Besteht ein chemisches Potentialgefälle zwischem dem Metallsalz bzw. den Metallkationen des wässrigen, Metallkationen-enthaltenden Elektrolyten und dem Material der zuvor strukturierten Precursorschicht, so wird das unedlere Metall der zuvor strukturierten Precursorschicht oxidiert, während die Metallkationen des Elektrolyten reduziert werden und sich auf der zuvor strukturierten Precursorschicht niederschlagen. Das Material der Precursor-Schicht unterliegt keiner spezifischen Beschränkung, ist aber vorzugsweise aus der Gruppe, bestehend aus Pd und Pd-Sn Kolloiden, d.h. Keimschichten aus Palladium oder Cluster aus Pd-Sn-Kolloiden, ausgewählt.

Gemäß der vorliegenden Erfindung wird eine miniaturisierte Hochfrequenz-Mikrospule, vorzugsweise aus Kupfer, in einem makroporösen Substrat verwendet. Im Rahmen eines entsprechenden NMR-Messverfahrens befindet sich der Analyt in unmittelbarer Näher der Spulenwindungen, wodurch ein verbessertes Signal/ Rausch-Verhältnis erzielt wird. Bei Anordnen einer Passivierungsschicht, wie z.B. aus $SiO_2$ oder $Si_3N_4$, durch z.B. Sputtern oder low temperature CVD kann die Spule ferner vor den chemischen Einflüssen des Analyten geschützt werden (Schutz der Metallbahnen vor Korrosion). Eine solche Passivierungsschicht kann auch auf Polymer-Basis, z.B. Poly-parylen, sein.

Eine übliche NMR-Meßvorrichtung umfasst weiter Permanentmagnet und Auswerteelektronik. Ein solcher Aufbau ist einem Fachmann wohlbekannt. Es können beispielsweise NdFeB-Magnete mit einem magnetischen Fluß von etwa 1 Tesla verwendet werden. Wegen der durch den erfindungsgemäß verwendeten miniaturisierten Detektionsspulenkörper ermöglichten geringen Probengröße läßt sich die Homogenitätsanforderung an das statische Magnetfeld leichter erfüllen. Bei geringen Probenvolumen ist es vorteilhaft, wenn sich der Analyt in der Mitte der Spule befindet. Aufgrund der Kapillarkräfte in dem makroporösen Substrat wird die Flüssigkeit in die Mitte der Poren gezogen. Dieser Effekt kann durch lokales Aufbringen von hydrophoben bzw. hydrophilen Schichten unterstützt werden.

Der Analyt umfaßt in der Regel ein geeignetes Lösungsmittel sowie darin enthalten eine oder mehrere zu untersuchende chemische Verbindungen. Vor dem Einleiten in den erfindungsgemäß verwendeten miniaturisierten Detektionsspulenkörper kann die zu untersuchende, mehrere Komponenten enthaltende Probe mittels chromatographischer Verfahren wie beispielsweise der Flüssigchromatographie(z.B. HPLC) oder aber mittels Kapillarelektrophorese in die einzelnen Komponenten aufgetrennt werden und nacheinander in den erfindungsgemäß verwendeten miniaturisierten Detektionsspulenkörper eingeleitet werden. Diese Komponenten können dann separat voneinander in der NMR-Meßvorrichtung NMR-spektroskopisch untersucht werden. Der Fluß durch den erfindungsgemäß verwendeten miniaturisierten Detektionsspulenkörper kann kontinuierlich erfolgen oder aber stufenweise. Ein stufenweiser Fluß bedeutet, daß jeweils nur ein bestimmtes Volumen des Analyts in den erfindungsgemäß verwendeten miniaturisierten Detektionsspulenkörper geführt wird, dieser Analyt NMR-spektroskopisch untersucht wird und anschließend durch eine weitere Probe ersetzt wird.

Die Figuren zeigen:

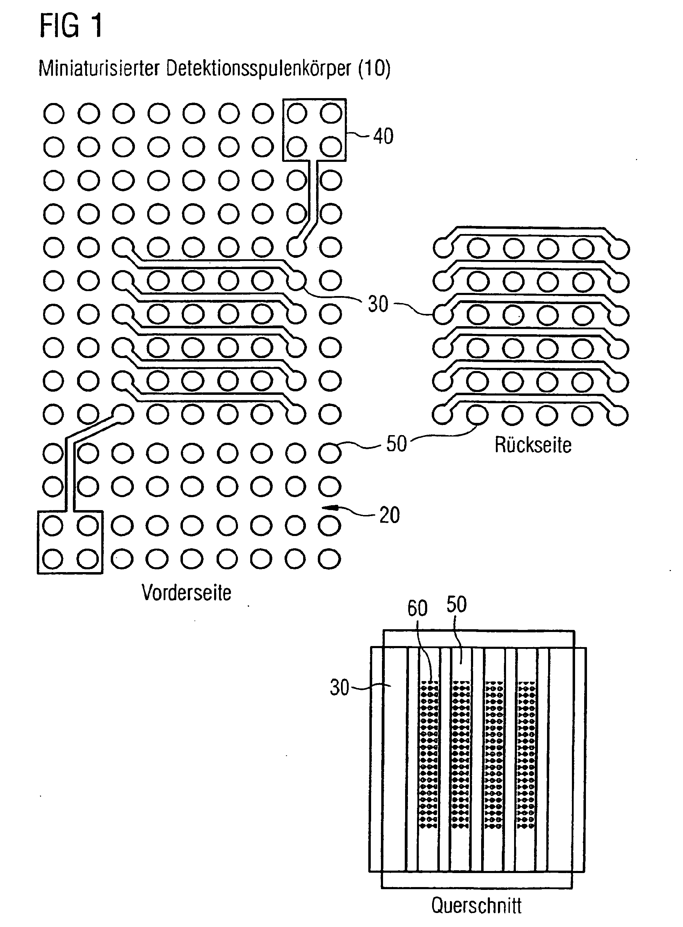

Figur 1 zeigt die Vorder- (Figur la) und Rückseite (Figur 1b) sowie den Querschnitt (Figur 1c) eines erfindungsgemäß verwendeten miniaturisierten Detektionsspulenkörpers 10, aufgebaut aus dem makroporösen Trägermaterial 20 und darin eingebettet die Mikrospule mit den Spulenwindungen 30 sowie Bondpads 40. In dem Substrat sind Makroporen 50 vorhanden. In dem Querschnitt ist außerdem der Analyt 60 in den Poren gezeigt.

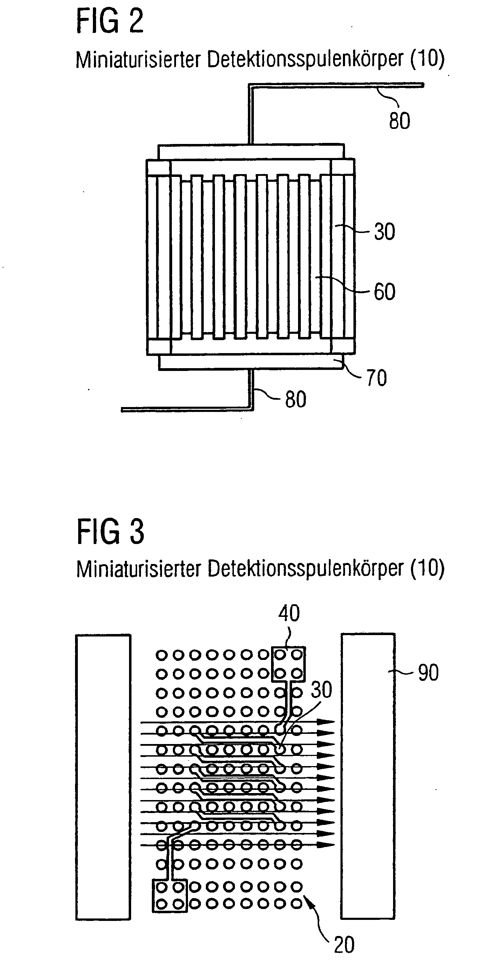

Figur 2 zeigt den Querschnitt eines erfindungsgemäß verwendeten miniaturisierten Detektionsspulenkörpers 10 in einem Bauteil für die NMR-spektroskopische Analyse von Flüssigphasenproben. Dabei ist der erfindungsgemäß verwendete miniaturisierte Detektionsspulenkörper 10 in ein Gehäuse mit fluidischer Abdichtung 70 eingefaßt und mit Zu- und Ableitung 80 für den Analyten versehen. Weiterhin ist ein Teil der Spule 30 in Form Metall gefüllter Poren sowie der Analyt 60 in den Poren dargestellt.

Figur 3 zeigt einen erfindungsgemäß verwendeten miniaturisierten Detektionsspulenkörper 10 in dem Magnetfeld ($B_{stat}$) eines Permanentmagneten 90 bzw. dessen Polschuhen einer NMR-Meßvorrichtung.

**Bezugszeichenliste**

10 miniaturisierter Detektionsspulenkörper
20 makroporöses Trägermaterial
30 Spulenwindungen
40 Bondpad
50 Makroporen
60 Analyt
70 Gehäuse mit fluidischer Abdichtung
80 Zu- und Ableitung für den Analyten
90 Permanentmagnet

**Patentansprüche**

1. Verwendung eines miniaturisierten Detektionsspulenkörpers (10) zur NMR-spektroskopischen Analyse kleinster Probenmengen einer Flüssigphasenprobe, insbesondere mit Probenvolumen von weniger als 1 $\mu$l,
   **dadurch gekennzeichnet,**

   - **dass** der miniaturisierte Detektionsspulenkörper ein makroporöses Trägermaterial (20) mit einer Dicke von 100 $\mu$m bis 5000 $\mu$m umfasst, das gegenüberliegend eine erste und eine zweite Oberfläche aufweist, wobei über einen Oberflächenbereich verteilt eine Vielzahl von diskreten Poren (50) mit einem Durchmesser im Bereich von 500 nm bis 100 $\mu$m und einer Dichte im Bereich von $10^4$ bis $10^8/cm^2$ angeordnet ist, welche sich durch das Trägermaterial (20) von der ersten zur zweiten Oberfläche erstrecken, und der Detektionsspulenkörper weiter eine Hochfrequenz-Mikrospule (30) mit einem an das Probenvolumen angepassten Querschnit von weniger als 500 $\mu$m x 500 $\mu$m umfasst, die in dem Oberflächenbereich in das makroporöse Trägermaterial eingebettet ist, wobei die Spulenwindungen von der ersten zur zweiten Oberfläche durch die Poren des makroporösen Trägermaterials verlaufen und die Kontaktierung der Spule auf einer Oberfläche des Trägermaterials erfolgt, und wobei die Porendichte im Feldbereich der Spule auf bis zu $10^{10}/cm^2$ vergrössert sein kann, und
   - **dass** die Verwendung beinhaltet, dass der Analyt durch die Poren in den sensitiven Bereich der Hochfrequenz-Mikrospule im Inneren des makroporösen Trägermaterials geführt wird.

2. Verwendung gemäss Anspruch 1, wobei das Trägermaterial (20) makroporöses Silizium ist.

3. Verwendung gemäss Anspruch 2, wobei eine Isolationsschicht aus $SiO_2$ oder $Si_3N_4$ auf die Gesamtoberfläche des makroporösen Siliziums, einschliesslich der gesamten Porenoberflächen, aufgebracht ist.

4. Verwendung gemäss einem der Ansprüche 1 bis 3, wobei die Makroporen (50) einen Durchmesser im Bereich von 2 $\mu$m bis 20 $\mu$m aufweisen.

5. Verwendung gemäss einem der Ansprüche 1 bis 4, wobei das Spulenmaterial Kupfer ist.

## Claims

1. Use of a miniaturized detection coil former (10) for the NMR spectroscopic analysis of extremely small amounts of a liquid-phase specimen, in particular with sample volumes of less than 1 $\mu$l, **characterized**

   - **in that** the miniaturized detection coil former comprises a macroporous carrier material (20) having a thickness of 100 $\mu$m to 5000 $\mu$m, which has a first surface and a second surface lying opposite one another, a multiplicity of discrete pores (50) with a diameter in the range from 500 nm to 100 $\mu$m and a density in the range from $10^4$ to $10^8$/cm$^2$ being arranged such that they are distributed over a surface region and extend through the carrier material (20) from the first surface to the second surface, and the detection coil former also comprising a radio-frequency microcoil (30) with a cross section adapted to the sample volume of less than 500 $\mu$m x 500 $\mu$m, which is embedded in the macroporous carrier material in the surface region, the coil windings running through the pores of the macroporous carrier material from the first surface to the second surface and the contacting of the coil taking place on one surface of the carrier material, and it being possible to increase the pore density in the field region of the coil to up to $10^{10}$/cm$^2$, and
   - **in that** the use comprises passing the analyte through the pores into the sensitive region of the radio-frequency microcoil in the interior of the macroporous carrier material.

2. Use according to Claim 1, the carrier material (20) being macroporous silicon.

3. Use according to Claim 2, an insulating layer of SiO$_2$ or Si$_3$N$_4$ being applied to the entire surface of the macroporous silicon, including the entire pore surfaces.

4. Use according to one of Claims 1 to 3, the macropores (50) having a diameter in the range from 2 $\mu$m to 20 $\mu$m.

5. Use according to one of Claims 1 to 4, the coil material being copper.

## Revendications

1. Utilisation d'un corps miniaturisé (10) de bobine de détection pour l'analyse par spectroscopie de RMN de très petites quantités d'échantillons en phase liquide, en particulier d'échantillons dont le volume est inférieur à 1 $\mu$l, **caractérisée en ce que**

   - le corps miniaturisé de bobine de détection comprend un corps macroporeux de support (20) d'une épaisseur de 100 $\mu$m à 5 000 $\mu$m qui présente une première et une deuxième surface opposées l'une à l'autre, plusieurs pores distincts (50) dont le diamètre est compris dans la plage de 500 nm à 100 $\mu$m et dont la densité est comprise dans la plage de $10^4$ à $10^8$/cm$^2$ étant répartis sur une partie de surface et s'étendent à travers le matériau de support (20) depuis la première jusqu'à la deuxième surface, le corps de bobine de détection présentant en outre une micro-bobine (30) à haute fréquence dont la section transversale, adaptée au volume de l'échantillon, est inférieure à 500 $\mu$m x 500 $\mu$m et incorporée dans la zone de surface du matériau macroporeux de support, les enroulements de la bobine s'étendant de la première à la deuxième surface par les pores du matériau macroporeux de support et le contact entre la bobine ayant lieu sur une surface du matériau de support, la densité de pores dans la zone du champ émis par la bobine pouvant être augmentée jusqu'à $10^{10}$/cm$^2$, et **en ce que**
   - l'utilisation comprend l'étape qui consiste à amener l'analyte par les pores jusque dans la zone sensible de la micro-bobine à haute fréquence à l'intérieur du matériau macroporeux de support.

2. Utilisation selon la revendication 1, dans laquelle le matériau de support (20) est un silicium macroporeux.

3. Utilisation selon la revendication 2, dans laquelle une couche d'isolation en SiO$_2$ ou Si$_3$N$_4$ est appliquée sur la totalité de la surface du silicium macroporeux et notamment sur la totalité de la surface des pores.

4. Utilisation selon l'une des revendications 1 à 3, dans laquelle les macropores (50) ont un diamètre compris dans la plage de 2 $\mu$m à 20 $\mu$m.

5. Utilisation selon l'une des revendications 1 à 4, dans laquelle le matériau de la bobine est le cuivre.

# FIG 1

Miniaturisierter Detektionsspulenkörper (10)

Vorderseite

Rückseite

Querschnitt

# FIG 2

Miniaturisierter Detektionsspulenkörper (10)

# FIG 3

Miniaturisierter Detektionsspulenkörper (10)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19927976 A1
- US 20020068369 A
- EP 0296348 A1

**In der Beschreibung aufgeführte Nicht-Patentliteratur**

- *Sensors and Actuators A,* 2003, vol. 105, 150-161